# EUROPEAN PATENT APPLICATION

(11) **EP 4 648 582 A1**
(43) Date of publication of application: **12.11.2025**
(21) Application number: 24738714.5
(22) Date of filing: 03.01.2024
(51) Int. Cl.: H10K 30/15, H10K 30/40, H10K 30/50, H10K 30/81, H10K 30/85, H10K 30/86, H10K 85/20, H10K 30/57

(54) **PEROVSKITE PHOTOELECTRIC CONVERSION DEVICE, PEROVSKITE SOLAR CELL COMPRISING SAME, AND MANUFACTURING METHOD THEREFOR**

(30) Priority: 04.01.2023 KR 20230001353
(71) Applicant: Hanwha Solutions Corporation, Jung-gu Seoul 04541 (KR)
(72) Inventor: CHOI, In Taek, Bucheon-si, Gyeonggi-do 14787 (KR)
(74) Representative: Mooser, Sebastian Thomas
(86) International application number: PCT/KR2024/000139
(87) International publication number: WO 2024/147644

(57) **Abstract**

The present invention relates to a perovskite photoelectric conversion device, a perovskite solar cell comprising same, and a manufacturing method therefor, the perovskite photoelectric conversion device having an interlayer introduced on one side of a perovskite light absorption layer through thermal evaporation.

## Description

### [Technical Field]

The present invention relates to a perovskite photoelectric conversion device in which an interlayer is introduced on one surface of a perovskite light absorption layer through a thermal evaporation process, a perovskite solar cell including the same, and a method of manufacturing the same.

### [Background Art]

A solar cell converts solar energy into electrical energy, and generates electrical energy using the photovoltaic effect in which electrons and holes are generated by absorbing solar energy.

Various types of solar cells have been proposed, and among them, a solar cell using a perovskite material, known as a material having the same crystal structure as calcium titanium oxide (CaTiO₃), as a light absorption layer is in the spotlight.

Perovskite solar cells are third-generation solar cells that combine thin film technology and have characteristics such as a high absorption coefficient, a variable band gap, and a rapid growth rate, compared to other types of solar cells. In addition, perovskite solar cells are superior to silicon solar cells in terms of price, strength, weight, and efficiency.

Meanwhile, perovskites used in solar cells generally have a three-dimensional crystal structure, and a perovskite with this crystal structure is used for a light absorption layer. In addition, a solar cell generally has a structure in which an electron transport layer and a hole transport layer are disposed on both sides of a perovskite light absorption layer having a three-dimensional crystal structure.

A perovskite light absorption layer having a three-dimensional crystal structure is generally formed into a thin film by applying a solution process or deposition process. Pb⁺ defects are generated on the surface and/or top of the perovskite formed as above, which reduces the open-circuit voltage (Voc) of a solar cell device. In addition, in a specific device structure, the p-i-n structure, there is a problem of a energy mismatch with the C₆₀ material applied on top of the perovskite, which reduces the fill factor (FF) of the solar cell device. To solve such a problem, previous studies attempted to solve the above problems by coating the perovskite surface with an ammonium-based material, which is an A-site material capable of forming a 2D perovskite, through a solution process to remove defects on its top and/or surface. In the n-i-p type perovskite solar cell structure, the open-circuit voltage (V_{OC}) and fill factor (FF) could be improved by the above method, but in the p-i-n type perovskite solar cell structure, due to the energy mismatch between the formed 2D perovskite material and the subsequent electron transport layer (ETL layer), C₆₀, another problem arises in which the short-circuit current density (J_{SC}) and fill factor (FF) are reduced.

Accordingly, to improve the energy mismatch with the C₆₀ material applied on top of the p-i-n type perovskite, an LiF layer was applied between the perovskite light absorption layer and the electron transport layer, thereby improving the open-circuit voltage (V_{OC}) and fill factor (FF). However, defect removal on the perovskite surface was not improved, and the separation of Li⁺ ions from the LiF material led to reduced stability of the solar cell device.

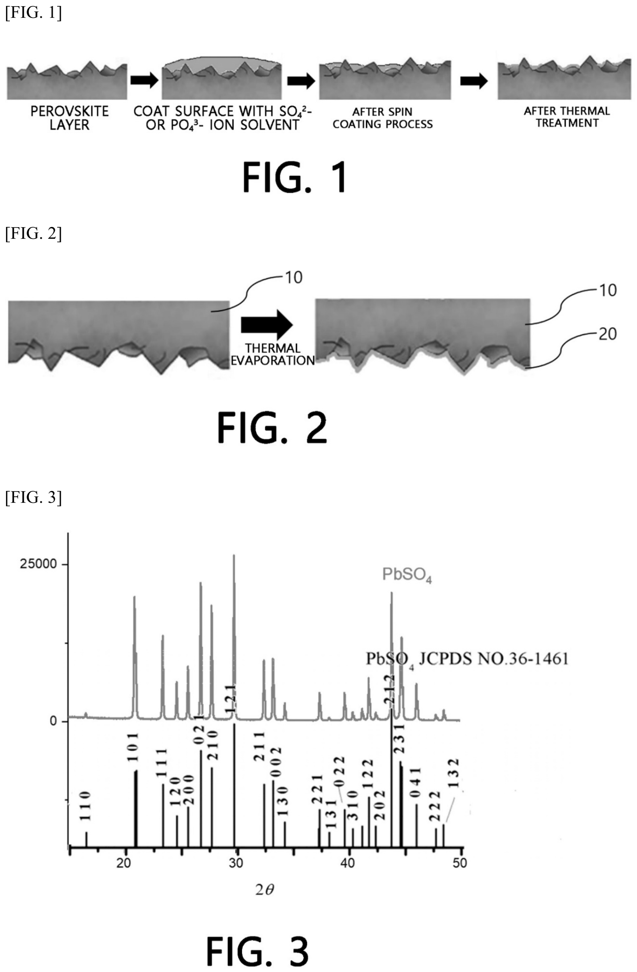

To overcome the above-mentioned problems, as shown in FIG. 1, the Pb⁺ defects and the energy mismatch problem between the perovskite and C₆₀ in the p-i-n structure were resolved by forming a thin film by coating the top surface of the perovskite with a (C₈H₁₇NH₃)₂SO₄ solvent capable of forming a lead oxysalt. However, there were problems such as surface contamination by unreacted (C₈H₁₇NH₃)²⁺ residues other than the SO₄²⁻ material reacting with Pb⁺, coverage of the solution process, and limitations in thickness uniformity.

### [Disclosure]

### [Technical Problem]

To overcome the above-described problems, the present invention is directed to providing a perovskite photoelectric conversion device which can solve a coverage issue caused by a solution process, limitations caused by thickness adjustment and remaining unreacted materials by introducing a thermal evaporation process to introduce an interlayer on top of a perovskite light absorption layer, a perovskite solar cell including the same, and a method of manufacturing the same.

In addition, the present invention is directed to providing a perovskite photoelectric conversion device with excellent photoelectric conversion efficiency and durability, a perovskite solar cell including the same, and a method of manufacturing the same.

### [Technical Solution]

To achieve the above-mentioned objects, a method of manufacturing a perovskite photoelectric conversion device of the present invention may include a first step of forming a hole transport layer on top of a first electrode, a second step of forming a perovskite light absorption layer on top of the hole transport layer, a third step of forming an interlayer on top of the perovskite light absorption layer through a thermal evaporation process, a fourth step of forming an electron transport layer on top of the interlayer, and a fifth step of forming a second electrode on top of the electron transport layer.

As an exemplary embodiment of the present invention, the interlayer may include one or more selected from lead sulfate (PbSO₄), lead phosphate (Pb₃(PO₄)₂), lead carbonate (PbCO₃), lead chromate (PbCrO₄), and lead oxalate (PbC₂O₄).

As an exemplary embodiment of the present invention, the interlayer may include lead sulfate (PbSO₄).

As an exemplary embodiment of the present invention, the lead sulfate may be prepared by reacting lead nitrate (Pb(NO₃)₂) with sodium sulfate (Na₂SO₄).

As an exemplary embodiment of the present invention, the lead sulfate may be prepared by reacting lead nitrate (Pb(NO₃)₂) with sodium sulfate (Na₂SO₄) in a molar ratio of 1 : 0.8 to 1.2.

As an exemplary embodiment of the present invention, the perovskite light absorption layer and the interlayer may have a thickness ratio of 1 : 0.0005 to 0.005.

As an exemplary embodiment of the present invention, the perovskite light absorption layer may include a compound represented by Chemical Formula 1.

[Chemical Formula 1] [A][B][X]₃

In Chemical Formula 1, A is a monovalent organic cation, a monovalent metal cation, or a mixed monovalent cation thereof, B is a divalent metal cation, and X is at least one anion.

The electron transport layer may include a fullerene-based organic material.

As an exemplary embodiment of the present invention, the fullerene-based organic material may include one or more selected from C₆₀, C₇₀, PC60BM, and PC70BM.

Meanwhile, the method of manufacturing a perovskite photoelectric conversion device according to the present invention may include a first step of forming a hole transport layer on top of a first electrode, a second step of forming an organic interfacial layer on top of the hole transport layer, a third step of forming a perovskite light absorption layer on top of the organic interfacial layer, a fourth step of forming an interlayer on top of the perovskite light absorption layer through a thermal evaporation process, a fifth step of forming an electron transport layer on top of the interlayer, and a sixth step of forming a second electrode on top of the electron transport layer.

Further, the perovskite photoelectric conversion device of the present invention may include a laminate in which a first electrode, a hole transport layer, a perovskite light absorption layer, an interlayer, an electron transport layer and a second electrode are sequentially stacked, and the interlayer may include one or more selected from lead sulfate (PbSO₄), lead phosphate (Pb₃(PO₄)₂), lead carbonate (PbCO₃), lead chromate (PbCrO₄), and lead oxalate (PbC₂O₄).

As an exemplary embodiment of the present invention, the interlayer may include lead sulfate (PbSO₄).

As an exemplary embodiment of the present invention, the perovskite light absorption layer and the interlayer may have a thickness ratio of 1 : 0.0005 to 0.005.

As an exemplary embodiment of the present invention, the electron transport layer may include a fullerene-based organic material.

As an exemplary embodiment of the present invention, the fullerene-based organic material may include one or more selected from C₆₀, C₇₀, PC60BM and PC70BM.

As an exemplary embodiment of the present invention, the laminate may further include an organic interfacial layer between the hole transport layer and the perovskite light absorption layer.

Meanwhile, a perovskite solar cell of the present invention includes the perovskite photoelectric conversion device of the present invention.

Further, a tandem silicon/perovskite heterojunction solar cell of the present invention may include the perovskite photoelectric conversion device of the present invention.

### [Advantageous Effects]

According to a perovskite photoelectric conversion device of the present invention, a perovskite solar cell including the same, and a method of manufacturing the same, excellent photoelectric conversion efficacy and long-term stability are achieved due to improved interfacial properties between a perovskite light absorption layer and an electron transport layer as an interlayer is introduced between the perovskite light absorption layer and the electron transport layer through a thermal evaporation process.

### [Description of Drawings]

FIG. 1 is a schematic diagram of a solution process that coats a perovskite surface with a (C₈H₁₇NH₃)₂SO₄ solvent capable of forming a lead oxysalt.
FIG. 2 is a schematic diagram illustrating the formation of an interlayer on top of a perovskite light activation layer through thermal evaporation in a method of manufacturing a perovskite photoelectric conversion device of the present invention.
FIG. 3 is a graph (upper graph) showing an XRD pattern of a reactant prepared in Preparation Example 1 of the present invention (the lower graph is theoretical data).

### [Modes of the Invention]

Hereinafter, the present invention will be described in detail.

To improve the energy mismatch with the C₆₀ material applied on top of a conventional p-i-n type perovskite, an LiF layer was applied between a perovskite light absorption layer and an electron transport layer, thereby improving an open-circuit voltage (V_{OC}) and a fill factor (FF). However, defect removal on the perovskite surface was not improved, and the separation of Li⁺ ions from the LiF material led to reduced stability of the solar cell device.

To overcome these problems, the Pb⁺ defects and the energy mismatch problem between the perovskite and C₆₀ in the p-i-n structure were resolved by forming a thin film by coating the top surface of the perovskite with a (C₈H₁₇NH₃)₂SO₄ solvent capable of forming a lead oxysalt. However, there were problems such as surface contamination by unreacted (C₈H₁₇NH₃)²⁺ residues other than the SO₄²⁻ material reacting with Pb⁺, coverage of the solution process, and limitations in thickness uniformity.

Accordingly, in the present invention, excellent photoelectric conversion efficacy and long-term stability are achieved due to improved interfacial properties between a perovskite light absorption layer and an electron transport layer as an interlayer is introduced between the perovskite light absorption layer and the electron transport layer through a thermal evaporation process.

The method of manufacturing a perovskite photoelectric conversion device of the present invention includes first to fifth steps.

First, in the first step of the method of manufacturing a perovskite photoelectric conversion device of the present invention, a hole transport layer may be formed on top of a first electrode.

The first electrode may include a conductive transparent substrate, and may be a transparent thin film on which indium tin oxide (ITO), fluorine-doped tin oxide (FTO), Sb₂O₃-doped tin oxide (ATO), gallium-doped tin oxide (GTO), tin-doped zinc oxide (ZTO), gallium-doped ZTO (ZTO:Ga), indium gallium zinc oxide (IGZO, indium-doped zinc oxide (IZO), or aluminum-doped zinc oxide (AZO) is deposited.

In addition, the thickness of the first electrode is, but not limited to, preferably, 50 to 200 nm, and more preferably, 100 to 170 nm.

The hole transport layer (HTL) is a layer that transports holes formed in the perovskite light absorption layer described below and blocks the movement of electrons, and may include an inorganic and/or organic hole transport material(s).

Here, the inorganic hole transport material may include one or more selected from a nickel oxide (NiOₓ), CuSCN, CuCrO₂, CuI, MoO, and V₂O₅.

In addition, the organic hole transport material may include one or more selected from a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidine-based compound, a porphyrin-based compound, a phthalocyanine-based compound, a polythiophene derivative, a polypyrrole derivative, a polyparaphenylenevinylene derivative, pentacene, coumarin 6 (3-(2-benzothiazolyl)-7-(diethylamino)coumarin), zinc phthalocyanine (ZnPC), copper phthalocyanine (CuPC), titanium oxide phthalocyanine (TiOPC), 2,2',7,7'-tetrakis(N,N-p-dimethoxyphenylamino)-9,9'-spirobifluorene (spiro-MeOTAD), copper(II) 1,2,3,4,8,9,10,11,15,16, 17, 18,22,23,24,25-hexadecafluoro-29H,31H-phthalocyanine (F16CuPC), boron subphthalocyanine chloride (SubPc), cis-di(thiocyanato)-bis(2,2'-bipyridyl-4,4'-dicarboxylic acid)-ruthenium(II) (N3), poly[3-hexylthiophene] (P3HT), poly[2-methoxy-5-(3',7'-dimethyloctyloxyl)]-1,4-phenylene vinylene (MDMO-PPV), poly[2-methoxy-5-(2"-ethylhexyloxy)-p-phenylene vinylene] (MEH-PPV), poly(3-octyl thiophene) (P3OT), poly(octyl thiophene) (POT), poly(3-decyl thiophene) (P3DT), poly(3-dodecyl thiophene) (P3DDT), poly(p-phenylene vinylene) (PPV), poly(9,9'-dioctylfluorene-co-N-(4-butylphenyl)diphenyl amine) (TFB), polyaniline, [2,22',7,77'-tetrkis (N,N-di-pmethoxyphenyl amine)-9,9,9'-spirobi fluorine] (spiro-MeOTAD), poly[2,1,3-benzothiadiazole-4,7-diyl[4,4-bis(2-ethylhexyl-4H-cyclopenta [2,1-b:3,4-b']dithiophene-2,6-diyl]] (PCPDTBT), poly[(4,4'-bis(2-ethylhexyl)dithieno[3,2-b:2',3'-d]silole)-2,6-diyl-alt-(2,1,3-benzothiadiazole)-4,7-diyl] (Si-PCPDTBT), poly(4,8-diethylhexyloxyl) (PBDTTPD), poly[2,7-(9-(2-ethylhexyl)-9-hexyl-fluorene)-alt-5,5-(4', 7,-di-2-thienyl-2',1', 3'-benzothiadiazole)] (PFDTBT), poly[2,7-.9,9-(dioctyl-fluorene)-alt-5,5-(4',7'-di-2-.thienyl-2', 1', 3'-benzothiadiazole)] (PFO-DBT), poly[(2,7-dioctylsilafluorene)-2,7-diyl-alt-(4,7-bis(2-thienyl)-2,1,3-benzothiadiazole)-5,5'-diyl] (PSiFDTBT), poly[[9-(1-octylnonyl)-9H-carbazole-2,7-diyl] -2,5-thiophenediyl-2,1,3-benzothiadiazole-4,7-diyl-2,5-thiophenediyl] (PCDTBT), poly(9,9'-dioctylfluorene-co-bis(N,N'-(4,butylphenyl))bis(N,N'-phenyl-1,4-phenylene)diamine (PFB), poly(9,9'-dioctylfluorene-cobenzothiadiazole) (F8BT), poly(3,4-ethylenedioxythiophene) (PEDOT), poly(3,4-ethylenedioxythiophene) poly(styrenesulfonate) (PEDOT:PSS), poly(triarylamine) (PTAA), 2-PACz, MeO-2PACz, Br-2PACz, Me-4PACz, MeO-4PACz, and 6-PACz.

In addition, as a method for forming the hole transport layer, a coating method and a vacuum deposition method may be used, and the coating method may include gravure coating, bar coating, printing, spraying, spin coating, dipping, and die coating.

In addition, the thickness of the hole transport layer is, but not limited to, preferably, 5 to 50 nm, and more preferably, 10 to 40 nm.

Next, the second step of the method of manufacturing a perovskite photoelectric conversion device of the present invention may be for forming a perovskite light absorption layer on top of the hole transport layer.

The perovskite light absorption layer may include a general perovskite material applied to a light absorption layer of a solar cell, and a perovskite with a 3D crystal structure may include a perovskite material that absorbs light at a wavelength of 300 to 800 nm. As an exemplary example, a compound represented by Chemical Formula 1 below may be included.

[Chemical Formula 1] [A][B][X]₃

In Chemical Formula 1, A is a monovalent organic cation, a monovalent metal cation, or a mixed monovalent cation thereof, B is a divalent metal cation, and X is at least one anion.

Specifically, A may include an amine, ammonium, a Group 1 metal, a Group 2 metal, and/or another cation or cation-like compound, and preferably, formamidinium (FA), methylammonium (MA), FAMA, CsFAMA, CsFA, or N(R)₄⁺ (here, R may be the same or different groups, and R is a C1 to C5 linear alkyl group, a C3 to C5 branched alkyl group, a phenyl group, an alkylphenyl group, an alkoxyphenyl group, or an alkylhalide).

In addition, B may include one or two selected from Fe, Co, Ni, Cu, Sn, Pb, Bi, Ge, Ti, Eu, and Zr.

In addition, X may include one or more halide elements selected from F, Cl, Br and I and/or Group 16 anions, and preferably, X may be IₓBr₃₋ₓ (0 ≤ x ≤ 3).

Meanwhile, the perovskite light absorption layer may be a single layer composed of the same perovskite material, or may be a multilayer structure in which multiple layers composed of different perovskite materials are stacked, and the light absorption layer consisting of one type of perovskite material may include one type of perovskite material and a different type of perovskite material from the one type of perovskite material, which has a pillar shape, such as a column shape, a plate shape, a needle shape, a wire shape, or a rod shape.

In addition, to form the perovskite light absorption layer, a coating method and a vacuum deposition method may be used, and the coating method may include gravure coating, bar coating, printing, spraying, spin coating, dipping, inkjet coating, and die coating.

Next, as shown in FIG. 2, the third step of the method of manufacturing a perovskite photoelectric conversion device of the present invention may be for forming an interlayer 20 on top of the perovskite light absorption layer 10 through a thermal evaporation process. The present invention not only removes defects on the surface of the perovskite light absorption layer but leads energy matching with the electron transport layer described later in the correct direction by introducing the interlayer through the thermal evaporation process.

Specifically, the interlayer may include one or more selected from lead sulfate (PbSO₄), lead phosphate (Pb₃(PO₄)₂), lead carbonate (PbCO₃), lead chromate (PbCrO₄), and lead oxalate (PbC₂O₄), and preferably, lead sulfate (PbSO₄).

Here, the lead sulfate may be prepared by reacting lead nitrate (Pb(NO₃)₂) with sodium sulfate (Na₂SO₄), preferably, reacting lead nitrate (Pb(NO₃)₂) with sodium sulfate (Na₂SO₄) in a molar ratio of 1 : 0.9 to 1.1, and more preferably, in a molar ratio of 1 : 0.95 to 1.05. When the molar ratio is less than 1 : 0.9, a problem of reduced yield may occur, and when the molar ratio is more than 1 : 1.1, a problem in the extraction of the final reaction product with high purity may occur.

Meanwhile, the perovskite light absorption layer 10 and the interlayer 20 of the present invention may have a thickness ratio of 1 : 0.0005 to 0.005, and preferably, 1 : 0.001 to 0.003, and when the thickness ratio is less than 0.0005, there may be problems with energy matching with the electron transport layer described later and coverage, and when the thickness ratio exceeds 0.005, the current of the solar cell may decrease due to increased insulation properties.

Next, the fourth step of the method of manufacturing a perovskite photoelectric conversion device of the present invention may be for forming an electron transport layer on top of the interlayer.

The electron transport layer (ETL) is a layer that transports electrons formed in the perovskite light absorption layer and blocks the movement of holes, and may include a fullerene-based organic material. Here, the fullerene-based organic material may include one or more selected from C₆₀, C₇₀, PC60BM and PC70BM, and preferably, C₆₀.

In addition, to form the electron transport layer, a coating method and a vacuum deposition method may be used, and the coating method may include gravure coating, bar coating, printing, spraying, spin coating, dipping, and die coating.

In addition, the thickness of the electron transport layer is, but not limited to, preferably, 5 to 30 nm, and more preferably, 10 to 15 nm.

Finally, the fifth step of the method of manufacturing a perovskite photoelectric conversion device of the present invention may be for forming a second electrode on top of the electron transport layer.

The second electrode may be formed by depositing a metal material through a deposition process, and preferably, a thermal evaporation process.

Here, the metal material may include one or more selected from Pt, Au, Ni, Cu, Ag, In, Ru, Pd, Rh, Ir, Os, C, and a conductive polymer.

In addition, the thickness of the second electrode is, but not limited to, preferably, 50 nm to 2.5 µm, and more preferably, 80 to 150 nm.

Meanwhile, another method of manufacturing a perovskite photoelectric conversion device of the present invention may include a first step of forming a hole transport layer on top of a first electrode, a second step of forming an organic interfacial layer on top of the hole transport layer, a third step of forming a perovskite light absorption layer on top of the organic interfacial layer, a fourth step of forming an interlayer on top of the perovskite light absorption layer through a thermal evaporation process, a fifth step of forming an electron transport layer on top of the interlayer, and a sixth step of forming a second electrode on top of the electron transport layer.

Specifically, unlike the above-described method of manufacturing a perovskite photoelectric conversion device of the present invention, an organic interfacial layer may be formed between the hole transport layer and the perovskite light absorption layer, and the organic interfacial layer may serve to improve hole transport ability and prevent recombination.

The organic interfacial layer may include an aromatic compound having a double bond, and may include, preferably, one or more selected from pyridine, aniline, carbazole, phenazine, phenoxazine, and phenothiazine. In addition, pyridine, aniline, carbazole, phenazine, phenoxazine, or phenothiazine may have another alkyl group linked at a carbon, oxygen, or nitrogen site, carboxyl acid, phosphorous acid, R4N⁺ halide anion groups (here, R may be H or C), or a group such as sulfonate may be included at the end of the alkyl group.

In addition, to form the organic interfacial layer, a coating method and a vacuum deposition method may be used, and the coating method may include gravure coating, bar coating, printing, spraying, spin coating, dipping, and die coating.

In addition, the thickness of the organic interfacial layer is, but not limited to, preferably, 1 to 10 nm, and more preferably, 1 to 3 nm.

Further, the perovskite photoelectric conversion device of the present invention may include a laminate in which a first electrode, a hole transport layer, a perovskite light absorption layer, an interlayer, an electron transport layer, and a second electrode are sequentially stacked. Here, the first electrode, the hole transport layer, the perovskite light absorption layer, the interlayer, the electron transport layer, and the second electrode are as described above.

In addition, the interlayer may include one or more selected from lead sulfate (PbSO₄), lead phosphate (Pb₃(PO₄)₂), lead carbonate (PbCO₃), lead chromate (PbCrO₄), and lead oxalate (PbC₂O₄), and preferably, lead sulfate (PbSO₄).

In addition, the perovskite light absorption layer and the interlayer of the present invention may have a thickness ratio of 1 : 0.0005 to 0.005, and preferably, 1 : 0.001 to 0.003.

In addition, the electron transport layer may include a fullerene-based organic material, and preferably, one or more selected from C₆₀, C₇₀, PC60BM, and PC70BM.

In addition, the laminate may further include an organic interfacial layer between the hole transport layer and the perovskite light absorption layer, and the organic interfacial layer is as described above.

Meanwhile, a perovskite solar cell of the present invention may include the perovskite photoelectric conversion device of the present invention.

In addition, a tandem silicon/perovskite heterojunction solar cell of the present invention may include the perovskite photoelectric conversion device of the present invention.

Hereinafter, the present invention will be described in further detail with reference to examples. However, the following examples are not intended to limit the scope of the present invention and should be interpreted merely as illustrations to aid in understanding the present invention.

### Preparation Example 1 : Preparation of composition for interlayer

A reactant was prepared by putting 25g (75.48 mmol) of lead nitrate (Pb(NO₃)₂), 10.72 g (75.48 mmol) of sodium sulfate (Na₂SO₄), and 50 mL of distilled water into a 250 mL flask and stirring the mixture for 1 hour. The reactant was filtered using a pressurized filter device, cleaned three times with 100 mL of distilled water, and subjected to XRD analysis. As a result, as shown in FIG. 3, it was confirmed that lead sulfate (PbSO₄) was prepared as a reactant and its yield was 96%.

### Example 1 : Manufacture of perovskite photoelectric conversion device

(1) As a first electrode, an ITO conductive transparent substrate with a size of 2.5 cm (W) × 2.5 cm (L) × 100 nm (T) was prepared. The prepared ITO conductive transparent substrate was immersed in a sodium hydroxide cleaning solution and subjected to ultrasonic cleaning for one hour. Afterward, the resulting substrate was cleaned again with distilled water and ethanol, and dried using nitrogen gas. After partially etching the ITO conductive transparent substrate that had been cleaned and dried with an IR laser, a hole transport layer (NiOₓ) with a thickness of 30 nm was formed on top of the ITO conductive transparent substrate by a sputter vacuum deposition method.
(2) Next, an organic interfacial layer with a thickness of 2 nm was formed by adding 200 µL of a solution for forming an organic interfacial layer dropwise onto the hole transport layer, and performing spin coating at 3000 rpm for 30 seconds and thermal treatment at 100 °C for 20 minutes. Here, as the solution for forming an organic interfacial layer, ethanol containing 1 mM 4-(3,6-dimethyl-9H-carbazol-9-yl)butyl]phosphonic acid (Me-4PACz) was used.
(3) Next, a perovskite light absorption layer with a thickness of 500 nm was formed by adding 100 µL of a 1.3M perovskite precursor solution with a perovskite crystal structure (Cs_{0.2}FA_{0.8}Pb(I_{0.8}Br_{0.2})₃) dropwise onto the organic interfacial layer, and performing spin coating at 5000 rpm for 30 seconds in a 99% pure nitrogen atmosphere and thermal treatment at 100 °C for 20 minutes.
(4) Next, an interlayer with a thickness of 1 nm was formed on top of the perovskite light absorption layer through a thermal evaporation process using a thermal evaporation instrument. Here, as an interlayer-forming material, the lead sulfate (PbSO₄) prepared in Preparation Example 1 was used.
(5) Next, an electron transport layer with an average thickness of 13 nm was formed by depositing C₆₀ fullerene on top of the interlayer through a vacuum deposition process.
(6) Next, an exciton blocking layer was formed by adding 200 µL of a solution in which 1 mg of bathocuproine was dissolved in 1 mL of isopropyl alcohol dropwise onto the electron transport layer, and performing spin coating at 4000 rpm for 30 seconds and thermal treatment at 100 °C for 20 minutes.
(7) Finally, a second electrode (Ag) with a thickness of 100 nm was formed on top of the exciton blocking layer through a thermal evaporation process using a thermal evaporation instrument, thereby completing the manufacture of a perovskite photoelectric conversion device.

### Comparative Example 1 : Manufacture of perovskite photoelectric conversion device

(1) As a first electrode, an ITO conductive transparent substrate with a size of 2.5 cm (W) × 2.5 cm (L) × 100 nm (T) was prepared. The prepared ITO conductive transparent substrate was immersed in a sodium hydroxide cleaning solution and subjected to ultrasonic cleaning for one hour. Afterward, the resulting substrate was cleaned again with distilled water and ethanol, and dried using nitrogen gas. After partially etching the ITO conductive transparent substrate that had been cleaned and dried with an IR laser, a hole transport layer (NiOx) with a thickness of 30 nm was formed on top of the ITO conductive transparent substrate by a sputter vacuum deposition method.
(2) Next, an organic interfacial layer with a thickness of 2 nm was formed by adding 200 µL of a solution for forming an organic interfacial layer dropwise onto the hole transport layer, and performing spin coating at 3000 rpm for 30 seconds and thermal treatment at 100 °C for 20 minutes. Here, as the solution for forming an organic interfacial layer, ethanol containing 1 mM 4-(3,6-dimethyl-9H-carbazol-9-yl)butyl]phosphonic acid (Me-4PACz) was used.
(3) Next, a perovskite light absorption layer with a thickness of 500 nm was formed by adding 100 µL of a 1.3M perovskite precursor solution with a perovskite crystal structure (Cs_{0.2}FA_{0.8}Pb(I_{0.8}Br_{0.2})₃) dropwise onto the organic interfacial layer, and performing spin coating at 5000 rpm for 30 seconds in a 99% pure nitrogen atmosphere and thermal treatment at 100 °C for 20 minutes.
(4) Next, an interlayer with a thickness of 1 nm was formed on top of the perovskite light absorption layer through a thermal evaporation process using a thermal evaporation instrument. Here, as an interlayer-forming material, lithium fluoride (LiF) was used.
(5) Next, an electron transport layer with an average thickness of 13 nm was formed by depositing C₆₀ fullerene on top of the interlayer through a vacuum deposition process.
(6) Next, an exciton blocking layer was formed by adding 200 µL of a solution in which 1 mg of bathocuproine was dissolved in 1 mL of isopropyl alcohol dropwise onto the electron transport layer, and performing spin coating at 4000 rpm for 30 seconds and thermal treatment at 100 °C for 20 minutes.
(7) Finally, a second electrode (Ag) with a thickness of 100 nm was formed on top of the exciton blocking layer through a thermal evaporation process using a thermal evaporation instrument, thereby completing the manufacture of a perovskite photoelectric conversion device.

### Comparative Example 2 : Manufacture of perovskite photoelectric conversion device

(1) As a first electrode, an ITO conductive transparent substrate with a size of 2.5 cm (W) × 2.5 cm (L) × 100 nm (T) was prepared. The prepared ITO conductive transparent substrate was immersed in a sodium hydroxide cleaning solution and subjected to ultrasonic cleaning for one hour. Afterward, the resulting substrate was cleaned again with distilled water and ethanol, and dried using nitrogen gas. After partially etching the ITO conductive transparent substrate that had been cleaned and dried with an IR laser, a hole transport layer (NiOx) with a thickness of 30 nm was formed on top of the ITO conductive transparent substrate by a sputter vacuum deposition method.
(2) Next, an organic interfacial layer with a thickness of 2 nm was formed by adding 200 µL of a solution for forming an organic interfacial layer dropwise onto the hole transport layer, and performing spin coating at 3000 rpm for 30 seconds and thermal treatment at 100 °C for 20 minutes. Here, as the solution for forming an organic interfacial layer, ethanol containing 1 mM 4-(3,6-dimethyl-9H-carbazol-9-yl)butyl]phosphonic acid (Me-4PACz) was used.
(3) Next, a perovskite light absorption layer with a thickness of 500 nm was formed by adding 100 µL of a 1.3M perovskite precursor solution with a perovskite crystal structure (Cs_{0.2}FA_{0.8}Pb(I_{0.8}Br_{0.2})₃) dropwise onto the organic interfacial layer, and performing spin coating at 5000 rpm for 30 seconds in a 99% pure nitrogen atmosphere and thermal treatment at 100 °C for 20 minutes.
(4) Next, a 2 mM solution was prepared by diluting octylamine and hydroperoxide (H₂O₄) in chloroform. A lead oxysalt interlayer with a thickness of 1 nm was formed by adding 200 µL of the prepared 2 mM solution dropwise onto the organic interfacial layer, and performing spin coating at 3000 rpm for 30 seconds and thermal treatment at 100 °C for 20 minutes.
(5) Next, an electron transport layer with an average thickness of 13 nm was formed by depositing C₆₀ fullerene on top of the interlayer through a vacuum deposition process.
(6) Next, an exciton blocking layer was formed by adding 200 µL of a solution in which 1 mg of bathocuproine was dissolved in 1 mL of isopropyl alcohol dropwise onto the electron transport layer, and performing spin coating at 4000 rpm for 30 seconds and thermal treatment at 100 °C for 20 minutes.
(7) Finally, a second electrode (Ag) with a thickness of 100 nm was formed on top of the exciton blocking layer through a thermal evaporation process using a thermal evaporation instrument, thereby completing the manufacture of a perovskite photoelectric conversion device.

### Comparative Example 3 : Manufacture of perovskite photoelectric conversion device

(1) As a first electrode, an ITO conductive transparent substrate with a size of 2.5 cm (W) × 2.5 cm (L) × 100 nm (T) was prepared. The prepared ITO conductive transparent substrate was immersed in a sodium hydroxide cleaning solution and subjected to ultrasonic cleaning for one hour. Afterward, the resulting substrate was cleaned again with distilled water and ethanol, and dried using nitrogen gas. After partially etching the ITO conductive transparent substrate that had been cleaned and dried with an IR laser, a hole transport layer (NiOx) with a thickness of 30 nm was formed on top of the ITO conductive transparent substrate by a sputter vacuum deposition method.
(2) Next, an organic interfacial layer with a thickness of 2 nm was formed by adding 200 µL of a solution for forming an organic interfacial layer dropwise onto the hole transport layer, and performing spin coating at 3000 rpm for 30 seconds and thermal treatment at 100 °C for 20 minutes. Here, as the solution for forming an organic interfacial layer, ethanol containing 1 mM 4-(3,6-dimethyl-9H-carbazol-9-yl)butyl]phosphonic acid (Me-4PACz) was used.
(3) Next, a perovskite light absorption layer with a thickness of 500 nm was formed by adding 100 µL of a 1.3M perovskite precursor solution with a perovskite crystal structure (Cs_{0.2}FA_{0.8}Pb(I_{0.8}Br_{0.2})₃) dropwise onto the organic interfacial layer, and performing spin coating at 5000 rpm for 30 seconds in a 99% pure nitrogen atmosphere and thermal treatment at 100 °C for 20 minutes.
(4) Next, a 4 mM solution was prepared by diluting octylamine and hydroperoxide (H₂O₄) in chloroform. A lead oxysalt interlayer with a thickness of 1 nm was formed by adding 200 µL of the prepared 4 mM solution dropwise onto the organic interfacial layer, and performing spin coating at 3000 rpm for 30 seconds and thermal treatment at 100 °C for 20 minutes.
(5) Next, an electron transport layer with an average thickness of 13 nm was formed by depositing C₆₀ fullerene on top of the interlayer through a vacuum deposition process.
(6) Next, an exciton blocking layer was formed by adding 200 µL of a solution in which 1 mg of bathocuproine was dissolved in 1 mL of isopropyl alcohol dropwise onto the electron transport layer, and performing spin coating at 4000 rpm for 30 seconds and thermal treatment at 100 °C for 20 minutes.
(7) Finally, a second electrode (Ag) with a thickness of 100 nm was formed on top of the exciton blocking layer through a thermal evaporation process using a thermal evaporation instrument, thereby completing the manufacture of a perovskite photoelectric conversion device.

### Experimental Example 1 : Measurement of performance of perovskite photoelectric conversion device

For each of the perovskite photoelectric conversion devices manufactured in Example 1 and Comparative Examples 1 to 3, the efficiency was measured based on the initial JV curve obtained using a solar simulator and a JV Keithley instrument, and the measurement results are shown in Table 1 below.

**[Table 1]**

| Classification | Open-circuit voltage (Voc, V) | Short-circuit current density (Jsc, mA/cm²) | Fill factor (FF) | Efficiency (%) |
|---|---|---|---|---|
| Example 1 | 1.183 | 21.27 | 79.66 | 20.05 |
| Comparative Example 1 | 1.175 | 20.88 | 73.44 | 18.03 |
| Comparative Example 2 | 1.154 | 21.11 | 76.59 | 18.66 |
| Comparative Example 3 | 1.182 | 20.77 | 76.79 | 18.87 |

As can be seen from Table 1, it can be confirmed that the photoelectric conversion device manufactured in Example 1 in which a uniform thin film of the PbSO₄ interlayer was formed on the perovskite surface through a thermal evaporation process is improved in all efficiency parameters compared to those manufactured in Comparative Examples 1 to 3.

### Comparative Example 4 : Manufacture of perovskite photoelectric conversion device

(1) As a first electrode, an ITO conductive transparent substrate with a size of 2.5 cm (W) × 2.5 cm (L) × 100 nm (T) was prepared. The prepared ITO conductive transparent substrate was immersed in a sodium hydroxide cleaning solution and subjected to ultrasonic cleaning for one hour. Afterward, the resulting substrate was cleaned again with distilled water and ethanol, and dried using nitrogen gas. After partially etching the ITO conductive transparent substrate that had been cleaned and dried with an IR laser, a hole transport layer (NiOx) with a thickness of 30 nm on top of the ITO conductive transparent substrate by a sputter vacuum deposition method.
(2) Next, an organic interfacial layer with a thickness of 2 nm was formed by adding 200 µL of a solution for forming an organic interfacial layer dropwise onto the hole transport layer, and performing spin coating at 3000 rpm for 30 seconds and thermal treatment at 100 °C for 20 minutes. Here, as the solution for forming an organic interfacial layer, ethanol containing 1 mM 4-(3,6-dimethyl-9H-carbazol-9-yl)butyl]phosphonic acid (Me-4PACz) was used.
(3) Next, a perovskite light absorption layer with a thickness of 500 nm was formed by adding 100 µL of a 1.3M perovskite precursor solution with a perovskite crystal structure (Cs_{0.2}FA_{0.8}Pb(I_{0.8}Br_{0.2})₃) dropwise onto the organic interfacial layer, and performing spin coating at 5000 rpm for 30 seconds in a 99% pure nitrogen atmosphere and thermal treatment at 100 °C for 20 minutes.
(4)Next, an electron transport layer with an average thickness of 13 nm was formed by depositing C₆₀ fullerene on top of the perovskite light absorption layer through a vacuum deposition process.
(5) Next, an exciton blocking layer was formed by adding 200 µL of a solution in which 1 mg of bathocuproine was dissolved in 1 mL of isopropyl alcohol dropwise onto the electron transport layer, and performing spin coating at 4000 rpm for 30 seconds and thermal treatment at 100 °C for 20 minutes.
(6) Finally, a second electrode (Ag) with a thickness of 100 nm was formed on top of the exciton blocking layer through a thermal evaporation process using a thermal evaporation instrument, thereby completing the manufacture of a perovskite photoelectric conversion device.

### Experimental Example 2 : Measurement of work function of perovskite photoelectric conversion device

The experimentally measured work functions of the surface of the perovskite light absorption layer of the perovskite photoelectric conversion device manufactured in Comparative Example 4 and the interlayer of the perovskite photoelectric conversion device manufactured in Example 1, obtained by XPS analysis, are shown in Table 2 below.

**[Table 2]**

| Classification | Work function (WF) | Valence band maximum (VBM) | Ionization energy (IE) |
|---|---|---|---|
| Example 1 | 5.05 eV | 2.89 eV | 7.94 eV |
| Comparative Example 4 | 5.49 eV | 0.39 eV | 5.88 eV |

As can be seen from Table 2, it can be confirmed that the introduction of the interlayer reduces the work function (WF) of perovskite by approximately 0.5eV, and such a WF reducing effect leads the energy matching with the electron transport layer consisting of C₆₀ fullerene in the correct direction.

Although embodiments of the present invention have been described above, the spirit of the present invention is not limited thereto, and it will be understood by those of ordinary skill in the art that the present invention may be modified and altered in various ways by adding, altering, or deleting a component without departing from the spirit of the present invention defined in the appended claims, and such modifications and alterations will also be included in the scope of the present invention.

## Claims

1. A method of manufacturing a perovskite photoelectric conversion device, comprising:
a first step of forming a hole transport layer on top of a first electrode;
a second step of forming a perovskite light absorption layer on top of the hole transport layer;
a third step of forming an interlayer on top of the perovskite light absorption layer through a thermal evaporation process;
a fourth step of forming an electron transport layer on top of the interlayer; and
a fifth step of forming a second electrode on top of the electron transport layer.

2. The method of claim 1, wherein the interlayer comprises one or more selected from lead sulfate (PbSO₄), lead phosphate (Pb₃(PO₄)₂), lead carbonate (PbCO₃), lead chromate (PbCrO₄), and lead oxalate (PbC₂O₄).

3. The method of claim 2, wherein the interlayer comprises lead sulfate (PbSO₄).

4. The method of claim 3, wherein the lead sulfate is prepared by reacting lead nitrate (Pb(NO₃)₂) with sodium sulfate (Na₂SO₄).

5. The method of claim 4, wherein the lead sulfate is prepared by reacting lead nitrate (Pb(NO₃)₂) with sodium sulfate (Na₂SO₄) in a molar ratio of 1 : 0.8 to 1.2.

6. The method of claim 1, wherein the perovskite light absorption layer and the interlayer have a thickness ratio of 1 : 0.0005 to 0.005.

7. The method of claim 1, wherein the perovskite light absorption layer comprises a compound represented by Chemical Formula 1:
[Chemical Formula 1] [A][B][X]₃
In Chemical Formula 1, A is a monovalent organic cation, a monovalent metal cation, or a mixed monovalent cation thereof, B is a divalent metal cation, and X is at least one anion.

8. The method of claim 1, wherein the electron transport layer comprises a fullerene-based organic material.

9. The method of claim 8, wherein the fullerene-based organic material comprises one or more selected from C₆₀, C₇₀, PC60BM, and PC70BM.

10. A method of manufacturing a perovskite photoelectric conversion device, comprising:
a first step of forming a hole transport layer on top of a first electrode;
a second step of forming an organic interfacial layer on top of the hole transport layer;
a third step of forming a perovskite light absorption layer on top of the organic interfacial layer;
a fourth step of forming an interlayer on top of the perovskite light absorption layer through a thermal evaporation process;
a fifth step of forming an electron transport layer on top of the interlayer; and
a sixth step of forming a second electrode on top of the electron transport layer.

11. A perovskite photoelectric conversion device, comprising:
a laminate in which a first electrode, a hole transport layer, a perovskite light absorption layer, an interlayer, an electron transport layer and a second electrode are sequentially stacked,
wherein the interlayer comprises one or more selected from lead sulfate (PbSO₄), lead phosphate (Pb₃(PO₄)₂), lead carbonate (PbCO₃), lead chromate (PbCrO₄), and lead oxalate (PbC₂O₄).

12. The device of claim 11, wherein the interlayer comprises lead sulfate (PbSO₄).

13. The device of claim 11, wherein the perovskite light absorption layer and the interlayer have a thickness ratio of 1 : 0.0005 to 0.005.

14. The device of claim 11, wherein the electron transport layer comprises a fullerene-based organic material.

15. The device of claim 14, wherein the fullerene-based organic material comprises one or more selected from C₆₀, C₇₀, PC60BM and PC70BM.

16. The device of claim 15, wherein the laminate further comprises an organic interfacial layer between the hole transport layer and the perovskite light absorption layer.

17. A perovskite solar cell comprising the perovskite photoelectric conversion device of claim 11.

18. A tandem silicon/perovskite heterojunction solar cell comprising the perovskite photoelectric conversion device of claim 11.
